# EUROPÄISCHE PATENTANMELDUNG

(11) **EP 0 822 587 A2**
(43) Veröffentlichungstag der Anmeldung: **04.02.1998**
(21) Anmeldenummer: 97111023.4
(22) Anmeldetag: 02.07.1997
(51) Int. Cl.: H01L 21/3205, H01L 21/66

(54) **Verfahren zur Herstellung von integrierten kapazitiven Strukturen**

(30) Priorität: 02.08.1996 DE 19631361
(71) Anmelder: SIEMENS AKTIENGESELLSCHAFT, 80333 München (DE)
(72) Erfinder: Allinger, Robert, 82008 Unterhaching (DE); Braun, Helga, Dr., 81545 München (JP); Kerber, Martin, Dr., 81827 München (DE); Mattausch, Hans-Jürgen, Higashi-Hiroshima 724 (JP)

(57) **Zusammenfassung**

Bei der Herstellung von integrierten Kondensatoren in integrierten Halbleiter-Bausteinen wird der Kondensator vor Inbetriebnahme mit einer Belastungsspannung beaufschlagt, die größer ist als die spätere Betriebsspannung. Dadurch entstehen in einer Isolationsschicht (3) Ladungen (6), die ein elektrisches Feld an kritischen Stellen abschirmen und so zu einer Passivierung führen.

## Beschreibung

Die Erfindung betrifft ein verfahren zur Herstellung von kapazitiven Strukturen in integrierten Halbleiter-Bausteinen mit hoher Isolationsfestigkeit.

Zur Optimierung der Eigenschaften von kapazitiven Strukturen in flüchtigen und nichtflüchtigen Halbleiterspeichern, wie z.B. in DRAMs oder EEPROMs, und auch in Logik-ICs werden dünne Isolationsschichten möglichst gleichmäßiger Dicke und homogener Morphologie benötigt. Für solche Isolationsschichten werden SiO₂, Si₃N₄ oder Sandwich-Strukturen (ONO) aus diesen Materialien eingesetzt. Bei der Isolationsfestigkeit der Isolationsschichten spielt die Feldemission an Kanten und Spitzen der sich gegenüberliegenden Kondensatorplatten eine entscheidende Rolle. Die Kondensatorplatten bestehen in der Regel aus monokristallinem Silizium, polykristallinem Silizium oder Aluminium. Besonders bei Verwendung von polykristallinem Silizium als Kondensatorplatten-Material kann an ebenen Flächen eine Spitzen- und Kantenbildung auftreten, da diese aus einzelnen Kristalliten unterschiedlicher Orientierung zusammengesetzt sind. Bei nichtflüchtigen Speichern, wie z.B. EEPROMs, und modernen dynamischen Speichern, mit beispielsweise Trench-Capacitor und Stacked Capacitor, sind außerdem geometriebedingte Kanten und Spitzen in den Kondensatorstrukturen vorhanden, an denen Feldemission und damit ein Leckstrom auftreten kann und nicht zu vermeiden ist. Diese Kanten und Spitzen und die daraus resultierende Feldemission sind der letztlich limitierende Faktor für zwei wichtige Randbedingungen des jeweiligen Designs des Halbleiter-Bausteins. zum einen wird die minimale Dicke der Isolationsschicht und damit die maximale Kapazität pro Flächeneinheit begrenzt. Diese Limitierung ist insbesondere bei DRAMs von Bedeutung. Zum anderen können Schwankungen im Einsatz der verschiedenen unerwünschten Leckstrom-Mechanismen, wie Fowler-Nordheim-Tunneln oder Poole-Frenkel-Leitung auftreten. Dies ist vor allem für das Floating Gate eines EEPROMs von Bedeutung.

Dieses Problem der Feldemission an Isolationsschichten in kapazitiven Strukturen von integrierten Halbleiter-Bausteinen ist beispielsweise aus "Nonplanar Oxidation and Reduction of Oxide Leakage Currents at Silicon Corners by Rounding-Off Oxidation", von K. Yamabe und K. Imai, IEEE Trans. Electron Devices 34, Seite 1681 (1987) bekannt. Hier wird bereits die Fertigungstechnologie darauf abgestellt, daß die Isolationsschicht mit einer gleichmäßigen Dicke ausgebildet wird und eine weitestgehende Vermeidung und Abrundung von Kanten und Spitzen sichergestellt wird. Da jedoch bei keinem Verfahren die Entstehung von Rauhigkeiten gänzlich ausgeschlossen werden kann, kann das Problem auf diese Weise nicht grundsätzlich gelöst werden.

Der Erfindung liegt die **Aufgabe** zugrunde, ein Verfahren der eingangs genannten Art zu schaffen, mit dem eine besonders sichere Isolationsschicht in kapazitiven Strukturen von Halbleiter-Bausteinen hergestellt werden kann, bei der keine Leckpfade auftreten.

Erfindungsgemäß wird die Aufgabe gelöst, indem die kapazitive-Struktur vor Inbetriebnahme mit einer Spannung belastet wird, die größer ist als die spätere Betriebsspannung.

Diese Lösung kann auch als aktive Selbstpassivierung der möglichen Leckpfade beschrieben werden, durch die das Problem der Feldemission an Kanten und Spitzen der beiden Kondensatorelektroden gelöst wird. Durch Anlegen einer höheren Spannung entsteht an den problematischen Kanten der unerwünschte Leckstrom, der in der Regel ein Elektronenstrom ist, wobei durch einen sogenannten "trapp-up"-Effekt permanente, feste, in der Regel negative Ladungen in der Isolationsschicht in der Umgebung dieser problematischen Kanten und Spitzen gebildet werden. Diese im Isolator erzeugten festen Ladungen, die durch die Leckströme hergestellt werden, schirmen die störenden Kanten und Spitzen elektrostatisch ab, wodurch eine weitere Feldemission bei Spannungen, die kleiner als diese Belastungsspannung,sind, also insbesondere die spätere Betriebsspannung, unterbunden wird.

Dieser bisher bekannte "trapp-up"-Effekt bezeichnet den Ladungsträgereinbau ausschließlich an ebenen Strukturen. An Kanten und Ecken sind die Effekte durch das inhomogene elektrische Feld anders. Der erfindungsgemäß verwendete "trapp-up"-Effekt unterscheidet sich daher von dem bisher bekannten "trapp-up"-Effekt. Dieser Effekt ist als ein negativer Effekt bekannt und wurde ausführlich an ebenen Oxiden von nichtflüchtigen Speichern untersucht. Dieser Effekt ist bisher in Tunneloxiden beobachtet und untersucht worden, wobei eine Anlagerung von Ladungen in dem Tunneloxid zu einer Verkleinerung des dort erwünschten Tunnelstroms führt und über höhere Programmierspannungen kompensiert werden muß. Letztendlich kann der "trapp-up"-Effekt zur Zerstörung des Tunneloxids führen. Beschrieben wird dieser Effekt beispielsweise in "Model for Oxide Wearout due to Charge Trapping", von W.K. Meyer und D.L. Crook, Proceedings of IEEE IRFS, Seite 242 (1983) und in "A model relating wearout and breakdown in thin silicon oxide films", von D.J. Dumin, J.R. Maddux, R.S. Scott und R. Subramoniam, Proceedings of the 4^{th} Symposium on the Physical and Failure Analysis of Integrated Circuits, Seite 20 (1993).

Durch die Erfindung wird in äußerst vorteilhafter Weise dieser bisher nur als negativ bekannte "trapp-up"-Effekt zur Unterbindung von unerwünschten Leckströmen in Isolationsschichten von kapazitiven Strukturen genutzt. Damit können die negativen Effekte von herstellungs- und geometriebedingten Spitzen und Kanten in integrierten kapazitiven Strukturen ausgeglichen werden. Komplizierte und kostenträchtige technologische Maßnahmen zur Beseitigung dieser Spitzen und Kanten, die nicht immer auch gleichmäßigen und reproduzierbaren Erfolg bringen, können vermieden werden. Darüber hinaus ist es auch leichter möglich, geometrische Strukturen einzusetzen, bei denen Spitzen und Kanten technologisch unvermeidbar sind.

Das erfindungsgemäße Verfahren wird in einer bevorzugten Ausführungsform direkt nach Herstellung der integrierten Halbleiter-Bausteine angewandt. Es besteht auch die Möglichkeit, die mit diesen Halbleiter-Bausteinen ausgerüsteten Geräte programmtechnisch so auszubilden, daß das erfindungsgemäße Verfahren erst beim Anwender direkt vor dem Einsatz durchgeführt wird.

Es ist günstig, die Spannung, mit der der Kondensator belastet wird, nur geringfügig größer als die spätere Betriebsspannung zu wählen, um den integrierten Halbleiter-Baustein zu schonen und um keine Durchbrüche in der regulären Isolationsschicht zu provozieren. Abhängig vom Halbleiter-Baustein kann die Feldstärke zwischen 0,1 bis 1,0 MV/cm über der bisherigen Betriebsfeldstärke liegen.

In einer bevorzugten Weiterbildung der Erfindung wird nach Anlegen der Spannung an den Kondensator eine Hochtemperaturlagerung durchgeführt, bei der es besonders günstig ist, diese über etwa 24 Stunden bei einer Temperatur von etwa 250° C durchzuführen.

Eine bevorzugte Weiterbildung der Erfindung besteht darin, das erfindungsgemäße Verfahren wiederholt auszuführen, da über einen langen Zeitraum gesehen die Möglichkeit besteht, daß sich die abschirmenden Ladungen zurückbilden. Durch eine Wiederholung des Verfahrens kann diese Rückbildung reduziert werden. Auch eine thermische Vorbehandlung der Halbleiter-Bausteine vor Durchführung des Verfahrens sowie eine erhöhte Temperatur während des Verfahrens führen zu günstigen Ergebnissen.

Das Verfahren wird bevorzugt bei EEPROM-Speichern eingesetzt, wodurch eine ganze Reihe von Vorteilen erreicht werden. Bei EEPROM-Speichern führt das erfindungsgemäße Verfahren zu einer schmalen reproduzierbaren Verteilung der Einsatzspannungen von Zellenfeldern auch bei an sich schlechten Voraussetzungen aufgrund der eingesetzten Herstelltechnologie und des verwendeten Zelldesigns. Weiterhin wird eine Verkleinerung der Oxiddicke, insbesondere zwischen dem Control Gate und dem Floating Gate möglich und damit eine Erhöhung der für die Programmierung entscheidenden Koppelkapazitäten. Für die Halbleiter-Bausteine, die solche EEPROM-Speicher enthalten, ergeben sich daraus weitere Produktvorteile. Durch die Herstellung kleinerer Speicherzellen, wobei die Fläche wesentlich durch die Koppelkapazität zwischen dem Control Gate und dem Floating Gate bestimmt wird, ergeben sich kleinere Chipflächen. Da die in solchen Halbleiter-Bausteinen benötigte Hochspannung im wesentlichen durch die zur Unterscheidung zwischen gespeicherter "0" und "1" erforderliche Schwellspannungsverschiebung sowie durch die Koppelkapazität zwischen Control Gate und Floating Gate bestimmt wird, können eventuell vorher erforderliche Schaltungsteile, wie z.B. der Substrat-Vorspannungsgenerator, eingespart werden. Ein weiterer, ganz wesentlicher Vorteil liegt in der Erhöhung der Fertigungsausbeute, der sich daraus ergibt, daß ein Großteil der ohne Passivierung außerhalb der zulässigen Toleranzen liegenden Zellen des Zellenfeldes durch die Passivierung des erfindungsgemäßen Verfahrens zu "guten" Zellen werden.

Ein anderes bevorzugtes Anwendungsgebiet sind DRAM-Speicher, da die eingesetzten Speicherkondensatoren hier ebenfalls rauhe, polykristalline Kondensatorplatten-Materialien sowie komplizierte geometrische Strukturen, wie z.B. Trench-Capacitor und Stacked-Capacitor, mit vielen Kanten und Spitzen aufweisen.

Ähnlich wie bei den EEPROMs ergeben sich hier die Vorteile, daß eine schmalere und reproduzierbare Verteilung der Leckströme in den Speicherkapazitäten der Einzelzellen von Zellenfeldern auch bei an sich schlechten Voraussetzungen aufgrund der eingesetzten Herstelltechnologie und des verwendeten Zelldesigns erreicht wird. Weiterhin ist eine Verkleinerung der Oxiddicken im gesamten Speicherkondensator und damit eine Erhöhung der Kapazität pro Flächeneinheit möglich. Das bedeutet für die IC-Produkte, die solche DRAM-Speicher enthalten, daß kleinere Speicherzellen und damit kleinere Chipflächen und eine Erhöhung der Fertigungsausbeute erreicht werden, weil ein Großteil der ohne Passivierung "schlechten" Zellen des Zellenfeldes nach der Passivierung zu "guten" Zellen werden. Beispielsweise kann bei solchen Zellen die Geschwindigkeit des Ladungsverlustes ohne das erfindungsgemäße Verfahren zu groß sein.

Ein weiteres bevorzugtes Anwendungsgebiet der Erfindung stellt die Anwendung auf integrierte Kondensatoren dar.

In einem alternativen Lösungsansatz wird die kapazitive Struktur insbesondere vor Inbetriebnahme mit mehreren Lösch/Programmierzyklen beaufschlagt, wodurch ebenfalls eine Selbstpassivierung erreicht werden kann. Unter "Inbetriebnahme" ist dabei nicht unbedingt die erste Inbetriebnahme des Gesamtbausteins zu verstehen, sondern die Durchführung dieser Lösch/Programmierzyklen vor der tatsächlichen Benutzung der kapazitiven Struktur. Grundsätzlich können die Lösch/Programmierzyklen jedoch auch nach "Inbetriebnahme" durchgeführt werden. Hier wird das Verfahren bevorzugt nach einer bestimmten Zeit- oder Betriebsdauer wiederholt.

Grundsätzlich genügen einige wenige Lösch/Programmierzyklen. So kann zum Beispiel mit einer Anzahl von ein bis fünf Lösch/Programmierzyklen eine reale Verbesserung der Isolationsfestigkeit erreicht werden. Durch Wiederholung erreicht man eine exponentielle Verbesserung, so daß vorzugsweise ca. 100 Zyklen durchgeführt werden.

Die vorher für den ersten Lösungsansatz beschriebenen Weiterbildungen, wie z.B. die Hochtemperaturlagerung oder die Durchführung des Verfahrens bei einer erhöhten Temperatur sind sinngemäß auch bei dieser alternativen Lösung anwendbar. Eine Wiederholung des Verfahrens erfolgt bevorzugt einschließlich der Hochtemperaturlagerung.

Nachfolgend wird die Erfindung anhand eines in der Zeichnung dargestellten Ausführungsbeispiels weiter erläutert. Im einzelnen zeigen die schematischen Darstellungen in
- Fig. 1: einen schematischen Querschnitt durch einen Kondensatorausschnitt vor Durchführung des erfindungsgemäßen Verfahrens;
- Fig. 2: einen schematischen Querschnitt durch einen Kondensatorausschnitt nach Durchführung des erfindungsgemäßen Verfahrens, und
- Fig. 3: ein Diagramm, welches die Ergebnisse des Verfahrens darstellt.

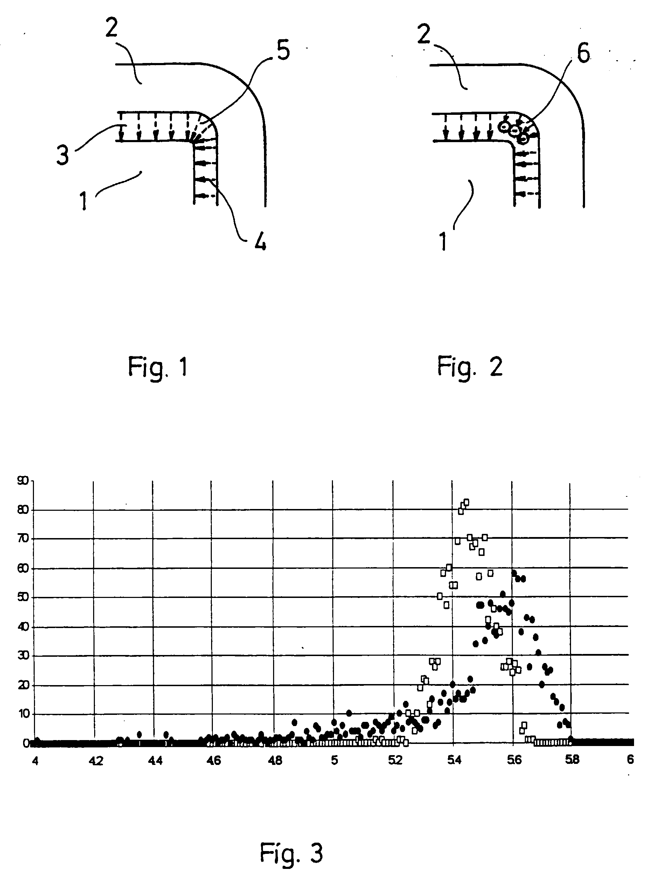

In Fig. 1 ist beispielhaft ein Querschnitt durch eine kapazitive Struktur einer EEPROM-Zelle dargestellt. Ein Floating Gate ist in der Figur mit 1 und ein Control Gate mit 2 bezeichnet. Floating Gate 1 und Control Gate 2 werden von Polysilizium1- und Polysilizium2-Schichten gebildet. Zwischen diesen ist ein isolierendes Oxid 3 angeordnet. In der Figur ist das Floating Gate 1 negativ geladen, so daß die EEPROM-Zelle in einem gelöschten Zustand ist. Die Pfeile 4 repräsentieren die elektrischen Feldlinien zwischen dem Control Gate 2 und dem Floating Gate 1. Im Bereich einer Ecke 5, an dem das Control Gate 2 das Floating Gate 1 überlappt, sind die Feldlinien 4 dichter und die Feldstärke höher. An dieser Stelle kann es zu Leckströmen oder gar Spannungsdurchbrüchen kommen. Die Situation könnte dadurch noch verschlechtert werden, daß zusätzlich Rauheitseffekte oder kristallitische Vorsprünge in den Polysiliziumschichten auftreten. Auch eine zufällig in diesem Bereich dünnere Oxidschicht 3 führt zu einer erhöhten Felddichte und damit zu potentiellen Leckströmen. Zudem ist die Oxidschicht 3 im Eckbereich 5 durch das Kurvendesign naturgemäß dünner und die Feldstärke höher.

In Fig. 2 ist die Situation nach Durchführung des erfindungsgemäßen Verfahrens dargestellt, wobei durch Anlegen einer höheren Spannung zwischen Floating Gate 1 und Control Gate 2 im Eckbereich 5 ein Leckstrom geflossen ist, wobei negative Ladungen 6 vom Isolator 3 eingefangen worden sind. Diese negativen Ladungen 6 schirmen jetzt das elektrische Feld im Eckbereich 5 ab und führen so zu einer Passivierung der kritischen Eck- und Kantenbereiche.

In Fig. 3 ist die Auswirkung des erfindungsgemäßen Verfahrens bei der Passivierung von mehreren EEPROM-Zellenfeldern einer Scheibe grafisch aufgetragen. Aufgetragen ist im gelöschten Zustand die Zahl der Einzelzellen N als Funktion der zugehörigen Einsatzspannung in Volt. Die vollen Kreise stellen die Zellen vor Durchführung des erfindunsgemäßen Verfahrens dar. Die Streuung der Einsatzspannungen in den nicht passivierten Zellenfeldern beträgt ca. ΔU_{form} = 1,9 V und wird in ihren Extremwerten durch schlechte Einzelzellen bestimmt, die einen besonders kritischen Leckpfad beinhalten. Nach Passivierung und selbst nach anschließender Hochtemperaturlagerung für 24 Stunden bei ca. 250° C haben die selben Zellen nur noch eine Streuung von ΔU_{form} = 0,4 V. Diese Zellen sind als gerahmte Kästchen dargestellt. Das Maximum der Verteilung verschiebt sich durch Hochtemperaturlagerung um ca. 200 mV zu kleineren Einsatzspannungen. Dieser Effekt wird durch einen gleichförmigen Ladungsverlust der Zellen während der Hochtemperaturlagerung verursacht. Bemerkenswert ist hierbei, daß auch die im nicht passivierten Zustand extrem "schlechten" Einzelzellen nach der Passivierung kein unterschiedliches Verhalten im Vergleich zu guten Zellen zeigen und sogar die Hochtemperaturlagerung ohne erhöhten Ladungsverlust überstehen.

## Patentansprüche

1. Verfahren zur Anwendung auf kapazitive Strukturen in integrierten Halbleiter-Bausteinen, bei dem die kapazitive Struktur mit einer Belastungsspannung beaufschlagt wird, die mindestens so groß ist wie die Betriebsspannung,
**dadurch gekennzeichnet,**
daß das Verfahren zur Erzeugung von kapazitiven Strukturen mit hoher Isolationsfähigkeit durch Passivierung von möglichen Leckpfaden in den kapazitiven Strukturen verwendet wird.

2. Verfahren nach Anspruch 1,
**dadurch gekennzeichnet,**
daß die Belastungsspannung direkt nach Herstellung des integrierten Halbleiter-Bausteins angelegt wird.

3. Verfahren nach einem der Ansprüche 1 oder 2,
**dadurch gekennzeichnet,**
daß die Belastungsspannung nur geringfügig höher ist als die spätere Betriebsspannung.

4. Verfahren nach einem der vorhergehenden Ansprüche,
**dadurch gekennzeichnet,**
daß die Belastungsspannung eine Belastungsfeldstärke hervorruft, die zwischen 0,1 und 1,0 MV/cm größer ist als eine spätere Betriebsfeldstärke, die durch die spätere Betriebsspannung hervorgerufen wird.

5. Verfahren nach einem der vorhergehenden Ansprüche,
**dadurch gekennzeichnet,**
daß nach Anlegen der Belastungsspannung an der kapazitiven Struktur eine Hochtemperaturlagerung durchgeführt wird.

6. Verfahren nach Anspruch 5,
**dadurch gekennzeichnet,**
daß die Hochtemperaturlager über etwa 24 Stunden bei einer Temperatur von etwa 250° C durchgeführt wird.

7. Verfahren nach einem der vorhergehenden Ansprüche,
**dadurch gekennzeichnet,**
daß das Verfahren wiederholt durchgeführt wird.

8. Verfahren nach einem der vorhergehenden Ansprüche,
**dadurch gekennzeichnet,**
daß eine thermische Vorbehandlung der integrierten Halbleiter-Bausteine durchgeführt wird.

9. Verfahren nach einem der vorhergehenden Ansprüche,
**dadurch gekennzeichnet**,
daß das Verfahren bei erhöhter Temperatur durchgeführt wird.

10. Verfahren nach Anspruch 9,
**dadurch gekennzeichnet**,
daß die erhöhte Temperatur zwischen 100 und 150°C liegt.

11. Verfahren nach einem der vorhergehenden Ansprüche,
**dadurch gekennzeichnet,**
daß das Verfahren bei EEPROM-Speichern angewendet wird.

12. Verfahren nach einem der Ansprüche 1 bis 10,
**dadurch gekennzeichnet,**
daß das Verfahren bei DRAM-Speichern angewendet wird.

13. Verfahren nach einem der Ansprüche 1 bis10,
**dadurch gekennzeichnet**,
daß das Verfahren bei integrierten Kondensatoren angewendet wird.

14. Verfahren zur Herstellung von kapazitiven Strukturen in integrierten Halbleiter-Bausteinen mit hoher Isolationsfestigkeit,
**dadurch gekennzeichnet**,
daß die kapazitive Struktur mit mehreren Lösch/Programmierzyklen mit Betriebsspannung beaufschlagt wird.

15. Verfahren nach Anspruch 14,
**dadurch gekennzeichnet**,
daß die Lösch/Programmierzyklen nach einer bestimmten Zeit oder Betriebsdauer wiederholt werden.

16. Verfahren nach Anspruch 14,
**dadurch gekennzeichnet**,
daß die Lösch/Programmierzyklen vor Inbetriebnahme durchgeführt werden.
